# EUROPÄISCHE PATENTSCHRIFT

(11) **EP 2 596 151 B1**
(45) Veröffentlichungstag und Bekanntmachung des Hinweises auf die Patenterteilung: **12.09.2018**
(21) Anmeldenummer: 11723364.3
(22) Anmeldetag: 16.05.2011
(51) Int. Cl.: H01L 39/24, C23C 24/04

(54) **VERFAHREN UND ANORDNUNG ZUR HERSTELLUNG VON SUPRALEITENDEN MAGNESIUMDIBORIDSCHICHTEN AUF SUBSTRATEN**
METHOD AND ARRANGEMENT FOR PRODUCING SUPERCONDUCTIVE LAYERS OF MAGNESIUM DIBORIDE ON SUBSTRATES
PROCÉDÉ ET ENSEMBLE POUR PRODUIRE DES COUCHES SUPERCONDUCTRICES EN DIBORURE DE MAGNÉSIUM SUR DES SUBSTRATS

(30) Priorität: 21.07.2010 DE 102010031741
(43) Veröffentlichungstag der Anmeldung: 29.05.2013
(73) Patentinhaber: Siemens Aktiengesellschaft, 80333 München (DE)
(72) Erfinder: ARNDT, Tabea, 91056 Erlangen (DE)
(86) Internationale Anmeldenummer: PCT/EP2011/057875
(87) Internationale Veröffentlichungsnummer: WO 2012/010339

(56) Entgegenhaltungen:
- EP-A1- 1 510 598
- WO-A1-2008/084951
- US-A1- 2003 127 051
- US-A1- 2006 083 694
- US-A1- 2007 190 309

## Beschreibung

Die vorliegende Erfindung bezieht sich auf ein Verfahren und eine Anordnung zur Herstellung von supraleitenden Schichten auf Substraten, wobei durch Aerosol-Deposition auf dem Substrat eine supraleitende Schicht aus MgB₂ hergestellt wird.

Der technische bzw. industrielle Einsatz von supraleitenden Drähten erfordert für die meisten Anwendungen große Längen. Diese Längen müssen nicht nur technisch, sondern auch kostengünstig herstellbar sein. Gerade in Hinblick auf Hochtemperatur-Supraleiter (HTS-Leiter) mit MgB₂-Material ist dies anspruchsvoll.

Im Wesentlichen gibt es für HTS-Leiter zwei Herstellprozesse, einmal die sogenannte Power-in-Tube (PIT) Methode und zum anderen Dünnschicht-Depositions-Verfahren wie z. B. Chemical-Vapor-Deposition (CVD), Metal-Organic-Chemical-Vapor-Deposition (MOCVD), Pulsed-Laser-Deposition (PLD), Sputtering, und thermisches Verdampfen. Den Dünnschicht-Depositions-Verfahren ist allen gemein, dass das Substrat sich auf einer hohen Temperatur befindet. Diese ist entweder durch das Verfahren an sich bestimmt, d.h. die notwendige Reaktionskinetik der Trägermedien, oder durch die Wachstumskinetik der Schicht, wie z. B. Temperaturfenster für die Texturbildung in den Schichten.

Die PIT-Methode wird für MgB₂ entweder in der sogenannten Ex-situ- oder der In-situ-Variation angewandt. Ex-situ beschreibt dabei die MgB₂-Phasenbildung außerhalb des Drahtes; bei der in-situ-Variation werden Komponenten gemischt und erst im Draht zu MgB₂ reagiert. Auch hier erfordern die Variationen hohe Temperaturen von z. B. 300...700°C.

Die hohen Temperaturen verbieten die Verwendung von Kupfer (Cu) im Draht oder erfordern integrierte Diffusionsbarrieren. Da Kupfer eines der am schnellsten diffundierenden Metalle ist, und da MgB₂ sehr sensitiv gegenüber Cu-Dotierung reagiert, d.h. degradiert, ist Kupfer in einer supraleitenden Schicht unerwünscht. Eine zusätzliche Diffusionsbarriere erniedrigt die Gesamtstromdichte und erschwert den Stromtransfer vom Supraleiter in das Shunt-Material. Die meisten Anwendungen der Energie- und Magnettechnik erfordern aber hinreichend gut leitendes und angekoppeltes Shunt-Material.

Diffusionsbarrieren oder Kupfer-Dotierungen im Supraleitermaterial führen nicht nur zu unerwünschten physikalischen Effekten oder erhöhen den technischen Auffand zur Herstellung von Drähten mit guten supraleitenden Eigenschaften, sie erhöhen auch die Kosten. So erfordert die Verwendung von Diffusionsbarrieren zusätzliche Herstellungsschritte bei der Draht- bzw. Kabel-Herstellung und Kupfer-Dotierungen führen im Betrieb zu höheren elektrischen Verlusten oder müssen durch einen erhöhten technischen Aufwand kompensiert werden. Hohe Depositions- bzw. Abscheidetemperaturen machen den Herstellungsprozess Energieaufwendiger und somit ebenfalls teurer.

Die Verwendung des Aerosol-Depositions-Verfahrens ermöglicht eine Abscheidung supraleitender Schichten bei nahezu Raumtemperatur bzw. bei im Wesentlichen Raumtemperatur, d.h. bei Temperaturen um die 25°C. Aus dem Stand der Technik ist das Aerosol-Depositions-Verfahren für die Herstellung von Beschichtungen für Mikromechanische Systeme, Displays, Brennstoffzellen, optischen Komponenten und Vorrichtungen für Hochfrequenzanwendungen bekannt. So ist z. B. im Artikel "Room Temperature Impact Consolidation (RTIC) of Fine Ceramic Powder by Aerosol Deposition Method and Applications to Microdevices" von Jun Akedo, Journal of Thermal Spray Technology, Volume 17(2), Juni 2008, Seiten 181ff, ein Verfahren zur Aerosol-Deposition auf diskreten Substraten zur Herstellung von Micro-Electro-Mechanic-Systems (MEMS) beschrieben. Nachteil der beschriebenen Methode ist die Verwendung von Vakuumkuum-Kammern zur Beschichtung der diskreten Substrate. Dabei wird das Substrat in einer Kammer auf einen Substrathalter mit Heizeinrichtung aufgebracht und unter Umständen Teile des Substrats mit Masken abgedeckt. Die Kammer wird vakuumdicht abgeschlossen, und in der Kammer wird über eine Pumpe ein Vakuum hergestellt. Anschließend wird das auf dem Substrathalter befestigte Substrat mit Maske über das Aerosol-Depositions-Verfahrens beschichtet. Nach abgeschlossener Beschichtung wird das beschichtete Substrat der Kammer entnommen, wobei es zur Verbesserung der Schichteigenschaften zuvor über die Heizeinrichtung erhitzt worden sein kann.

In der WO2008/084951A1 wird eine Methode zur Beschichtung von Kohlenstoffnanoröhrchen auf Substraten mittels Sprühbeschichtung aus einem Aerosol offenbart. Zusätzlich zu den Kohlenstoffnanoröhrchen kann das Aerosol dabei eine weitere Komponente wie beispielsweise MgB2 aufweisen.

Nachteil der beschriebenen Methode ist, dass mit dem beschriebenen Aufbau nur diskrete Substrate nacheinander, d.h. mit zeitlichen Abstand beschichtet werden können und zum Einbringen der Substrate in die Kammer, zur Vakuumerzeugung und zum Entnehmen der beschichteten Substrate aus der Kammer viel Zeit und Energie aufgewendet werden müssen, und somit Kosten entstehen.

Das Dokument EP1419538 offenbart ein Verfahren und Reaktoren zur kontinuierlichen Herstellung von Supraleiterschichten. Aufgabe der vorliegenden Erfindung ist es deshalb, ein Verfahren und eine Anordnung zur Herstellung von supraleitenden Schichten auf Substraten anzugeben, welche keine diskrete, zeitlich mit Abstand aufeinanderfolgende Abscheidung des supraleitenden Materials erfordern, und welche geringen Aufwand und geringe Kosten verursachen. Weiterhin ist es Aufgabe, bei geringem Energieverbrauch zuverlässig supraleitende Schichten z. B. auf bandförmigem Material kontinuierlich abscheiden zu können, ohne eine Kontamination des supraleitenden Materials z. B. durch verstärkte Diffusion von Kupfer bei hohen Temperaturen zu erhalten.

Die angegebene Aufgabe wird bezüglich des Verfahrens zur Herstellung von supraleitenden Schichten auf Substraten mit den Merkmalen des Anspruchs 1 und bezüglich der Anordnung zur Herstellung von supraleitenden Schichten auf Substraten mit Hilfe des zuvor beschriebenen Verfahrens mit den Merkmalen des Anspruchs 15 gelöst.

Vorteilhafte Ausgestaltungen des Verfahrens zur Herstellung von supraleitenden Schichten auf Substraten und der Anordnung zur Herstellung von supraleitenden Schichten auf Substraten mit Hilfe des zuvor beschriebenen Verfahrens gehen aus den zugeordneten abhängigen Unteransprüchen hervor. Dabei können die Merkmale der Unteransprüche untereinander kombiniert werden.

Bei dem erfindungsgemäßen Verfahren zur Herstellung von supraleitenden Schichten auf Substraten wird durch Aerosol-Deposition auf dem Substrat eine supraleitende Schicht aus MgB₂ hergestellt. Das Verfahren wird als ein kontinuierlicher Durchlaufprozess durchgeführt, bei dem das Substrat kontinuierlich bereitgestellt wird.

Dies ermöglicht die Herstellung von langen supraleitenden Drähten bzw. Kabeln. Für die Aerosol-Deposition ist kein Hoch-Vakuum notwendig, wodurch Aufwand und Kosten gering gehalten werden. Niedrige Temperaturen im Bereich von Raumtemperatur ermöglichen eine Abscheidung unter geringem Energieverbrauch und ohne eine Kontamination des supraleitenden Materials z. B. durch verstärkte Diffusion von Kupfer bei hohen Temperaturen.

Der kontinuierliche Prozess kann als Durchlaufprozess mit einem Substrat erfolgen, welches von einer Rolle kontinuierlich bereitgestellt wird. Alternativ zu einer Rolle kann das Material auch von einem anders geformten Träger abgewickelt werden oder spulenförmig ohne Träger vorliegen. Die Verwendung einer Rolle bewirkt eine ungehinderte Zuführung des Substrats für die Aerosol-Deposition ohne Verknotung oder Verhedderung des Substrats.

Das Substrat kann in Form von Bändern vorliegen und bei sehr langen bandförmigen Substraten gut von z. B. einer Rolle abgewickelt werden. Dadurch kann eine kontinuierliche Zuführung von Substrat zum Abscheideprozess gewährleistet werden. Als Bänder werden dabei bezeichnet langgestreckte, streifenförmige Substrate, insbesondere mit einem rechteckigen Querschnitt. Die Bänder weisen eine flache Oberseite auf, auf welcher das supraleitende Material abgeschieden werden kann. Die Oberseite kann insbesondere in Hinblick auf die Seitenflächen flächig viel ausgedehnter sein.

Es kann ein metallisches Substrat verwendet werden, insbesondere ein Substrat aus Kupfer oder Stahl. Kupfer weist gute elektrische Eigenschaften auf, um z. B. Fehlstellen im supraleitenden Material als Bypass zu überbrücken. Stahl hingegen weist eine höhere mechanische Stabilität auf. Auch Kombinationen der Materialien, insbesondere in laminierter Form oder als Legierungen, sind möglich.

Die supraleitende Schicht kann aus MgB₂ Pulver hergestellt werden. Alternativ kann die supraleitende Schicht aus einem Pulvergemisch von Mg und B hergestellt werden, welches im Nachhinein, d.h. nach der Aerosol-Deposition, zu MgB₂ reagiert wird. Dabei kann eine Temperaturnachbehandlung z. B. im Bereich von größer 800°C nach der Aerosol-Deposition dienen. Auch bei Verwendung von MgB₂ Pulver als Ausgangsmaterial kann eine zuvor beschriebene Temperaturnachbehandlung zu einer Verbesserung der supraleitenden bzw. elektrischen Eigenschaften der abgeschiedenen Schicht dienen. Eine Herstellung ohne einen Temperaturschritt mit hohen Temperaturen wie z. B. höher 800°C ist ebenfalls möglich durch die Verwendung des Aerosol-Depositions-Verfahrens, wodurch z. B. eine Verwendung von Kupfer-Substrat ohne Diffusionsbarriere-Schicht zwischen Kupfer und supraleitendem Material möglich ist, ohne kontaminierende Diffusion von Kupfer in das supraleitende Material. Die supraleitende Schicht kann auch aus MgB₂ Pulver und/oder Mg und B Pulver gemischt mit Shunt-Material, insbesondere einer FeCr-Ni- oder Cu-Ni-Legierung, hergestellt werden. Das Shunt-Material sorgt dann für eine gute elektrische Überbrückung von Fehlstellen im supraleitenden Material oder für eine gute elektrische Verbindung zwischen supraleitenden Kristalliten.

Als Trägergas für die Aerosolherstellung und Aerosol-Deposition kann Helium, Stickstoff oder Luft verwendet werden. Stickstoff ist dabei kostengünstig und birgt im Vergleich zu Luft nicht die Gefahr von Oxidation am Verfahren beteiligter Stoffe.

Das Verfahren kann bei im Wesentlichen Raumtemperatur, insbesondere bei 25°C durchgeführt werden. Dadurch ergeben sich die schon zuvor beschrieben Vorteile wie geringe Kosten, geringer Energieaufwand und verringerte bzw. keine Diffusion von Stoffen wie Kupfer in das supraleitenden Material und somit keine Kontamination des supraleitenden Materials. Dadurch wird z. B. ein Einsatz von Kupfer als Substrat ohne Diffusionsbarriere-Schichten erst möglich.

Die supraleitende Schicht kann mit einer Schichtdicke von größer oder gleich 1µm erzeugt werden. Das Aerosol-Depositions-Verfahren erlaubt gerade im Vergleich zu anderen Abscheidungsverfahren wie Sputtern die Erzeugung dicker Schichten, insbesondere mit geringem Zeit und Kostenaufwand.

Das Verfahren kann in einer Beschichtungskammer durchgeführt werden, welche wenigstens eine Schleuse aufweist, insbesondere eine Schleuse zum Zuführen des Substrats und eine Schleuse zum Abführen des Substrats, d.h. zwei Schleusen für eine Trennung des Innenraums der Beschichtungskammer von der Umgebungsatmosphäre der Beschichtungskammer. Dadurch kann bei gewünschten Drücken gearbeitet werden und unter z. B. Schutzgasatmosphäre, und/oder es kann eine Kontamination durch z. B. Schmutz oder Staub aus der Umgebung verhindert werden. Über die Schleusen ist die Beschichtungskammer gegenüber der Umwelt abgeschlossen und die Schichten können Kontaminationsfrei hergestellt werden.

Alternativ kann das Verfahren auch in einer Anordnung durchgeführt werden, welche vollständig gekapselt ist gegenüber der Umgebung, insbesondere zum luftdichten Abschluss des Verfahrens gegenüber der Umgebungsatmosphäre der Anordnung. Dabei kann die Anordnung eine Quellrolle an Substrat und/oder eine Zielrolle für das beschichtete Substrat schon umfassen in dem gekapselten Raum, wodurch kontinuierlich betriebene Schleusen für das Substrat und das beschichtete Substrat entfallen können. Es können noch Schleusen verwendet werden zum Bestücken der Anlage mit z. B. einer Substrat-Rolle und zum entnehmen der Rolle mit fertig beschichteten Substrat. Diese sind jedoch technisch einfacher auszuführen als kontinuierlich funktionierende Schleusen, wie sie in dem Beispiel zuvor beschrieben wurden. Die weiteren Vorteile sind analog dem zuvor beschriebenem Beispiel.

Auf die Aerosol-Deposition kann ein weiterer Beschichtungsprozess folgen, insbesondere eine Beschichtung zur Erzeugung einer Kupfer- und/oder Aluminium-Schicht. Diese Schicht kann als Bypass dienen, um bei Zusammenbruch der Supraleitung eine normale elektrische Leitung aufrecht zu erhalten und/oder um Fehlstellen in der supraleitenden Schicht elektrisch zu überbrücken. Die Schicht kann auch zur weiteren mechanischen Stabilisierung dienen. Darauf folgend kann ein Isolationsprozess durchgeführt werden.

Alternativ kann direkt folgend auf die Aerosol-Deposition auch ein Isolationsprozess durchgeführt werden. Damit wird ein supraleitendes Kabel oder ein supraleitender Draht fertig gestellt, ohne weitere Schritte, und elektrisch gegen die Umgebung isoliert.

In einem ersten Schritt des erfindungsgemäßen Verfahrens zur Herstellung von supraleitenden Schichten auf Substraten kann ein Trägergas in eine Aerosolkammer über einen gasdurchlässigen Support eintreten, wobei auf dem Support Pulver angeordnet wird, welches bei der Durchströmung des Supports von dem Trägergas teilchenförmig aufgenommen wird. In einem zweiten Schritt kann das Trägergas-Pulver-Gemisch über eine insbesondere regel- oder steuerbare Düse, insbesondere einer Düse in Schlitzform, in eine Beschichtungskammer eingeleitet werden, wobei das Pulver über einen Aerosol-Depositions-Prozess an einem kontinuierlich durch die Beschichtungskammer bewegtem Substrat abgeschieden wird.

Zwischen dem ersten und dem zweiten Schritt kann zeitlich ein dritter Schritt erfolgen, bei welchem das Aerosol aus Pulver und Trägergas durch einen Konditionierer strömt, in welchem für die Deposition zu große Pulver-Teilchen herausgefiltert werden und/oder eine Harmonisierung der kinetischen Energie der Pulver-Teilchen erfolgt. Dadurch wird die hergestellte supraleitende Schicht von ihrer Struktur her gleichmäßiger und erhält bessere elektrische Eigenschaften.

Eine erfindungsgemäße Anordnung zur Herstellung von supraleitenden Schichten auf Substraten kann eine Beschichtungskammer mit wenigstens einem Eingang zur kontinuierlichen Zuführung eines auf einer Rolle vorliegenden bandförmigen Substrates umfassen und wenigstens einen Ausgang für das mit einer supraleitenden Schicht beschichtete bandförmige Substrat. Weiterhin kann die Anordnung eine Vorrichtung zur Bereitstellung eines Aerosols zur Beschichtung des Substrats mit MgB₂ umfassen, die eine Aerosolkammer mit einer Trägergaszuleitung zur Herstellung eines Aerosols aus einem zugeführten Trägergas und einem in der Aerosolkammer enthaltenen Pulver aus MgB₂-Partikeln aufweist, wobei die Aerosolkammer mit der Beschichtungskammer zur Zufuhr des Aerosols in Verbindung steht. Mit der Anordnung kann ein zuvor beschriebenes Verfahren durchgeführt werden, wobei die zuvor beschriebenen Vorteile des Verfahrens ebenfalls für die Anordnung gelten.

Bevorzugte Ausführungsformen der Erfindung mit vorteilhaften Weiterbildungen gemäß den Merkmalen der abhängigen Ansprüche werden nachfolgend anhand der Figuren näher erläutert, ohne jedoch darauf beschränkt zu sein.

Es wird in den Figuren dargestellt:
- Figur 1: eine schematische Schnittdarstellung einer erfindungsgemäßen Anordnung 1 zur Herstellung von supraleitenden Schichten auf Substraten 15 durch Aerosol-Deposition, und
- Figur 2: eine schematische Schnittdarstellung der in Fig. 1 dargestellten Anordnung 1, jedoch vollständig gekapselt.

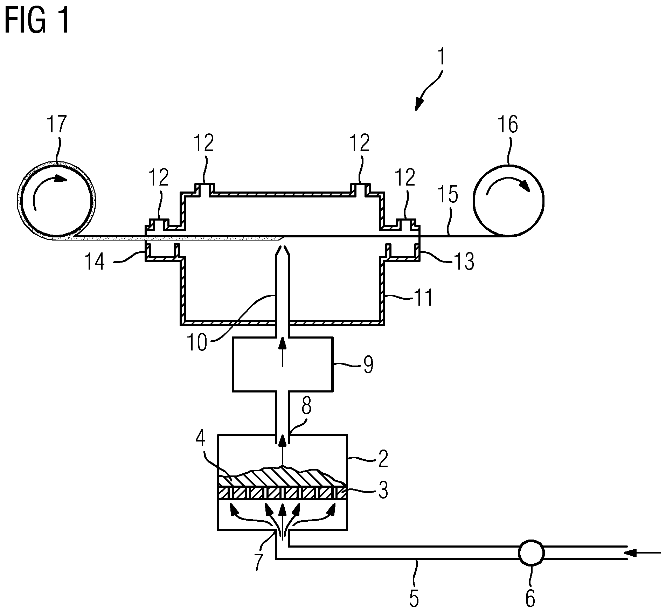

In der Fig. 1 ist eine schematische Schnittdarstellung der erfindungsgemäßen Anordnung 1 zur Herstellung von supraleitenden Schichten auf Substraten 15 durch Aerosol-Deposition gezeigt. Mit dieser Anordnung 1 ist das zuvor beschriebene erfindungsgemäße Verfahren ausführbar.

Die Anordnung 1 umfasst eine Aerosolkammer 2 zur Herstellung eines Aerosols aus einem Pulver 4 und einem Trägergas. Das Trägergas wird über eine Trägergaszuleitung 5 der Aerosolkammer 2 zugeführt. Als Trägergas kann z. B. Stickstoff verwendet werden. Der Zustrom und somit der Druck und eingangsseitig der Massenfluss des Trägergases wird über einen Gasregler 6, welcher in der Trägergaszuleitung 5 eingebaut ist, geregelt oder gesteuert. Das Trägergas strömt über einen Eingang 7 in die Aerosolkammer 2. Der Eingang 7 ist am unteren Ende der Aerosolkammer 2 angeordnet. In der Aerosolkammer 2 strömt das Trägergas von unten her kommend durch einen gasdurchlässigen Support 3, auf welchem ein Pulver angeordnet ist. Das Pulver kann z. B. aus MgB₂ Partikeln bestehen. Vom Gasdurchlässigen Support 3 her kommend strömt das Trägergas durch das Pulver und reißt durch die Strömung Pulverpartikel mit sich. Dadurch wird ein Aerosol gebildet. Das Aerosol aus Trägergas und Partikel verlässt die Aerosolkammer 2 am oberen Ende durch einen Ausgang 8. Über eine Rohrleitung verbunden oder direkt an die Aerosolkammer 2 insbesondere fluiddicht angeschlossen ist ein Konditionierer 9 angeordnet. Das Aerosol strömt durch den Konditionierer 9, wobei zu große Teilchen herausgefiltert werden und eine Harmonisierung der kinetischen Energie der im Aerosol verbleibenden Teilchen erfolgt. Eine erfindungsgemäße Anordnung kann aber auch ohne Konditionierer 9 aufgebaut sein. Dadurch wird der Aufbau vereinfacht, die abgeschiedenen Schichten sind dann aber weniger gleichmäßig mit schlechteren elektrischen, insbesondere supraleitenden Eigenschaften.

Vom Konditionierer 9 aus strömt das Aerosol über eine Düse 10, welche an einem Austrittsende schlitzförmig ausgebildet sein kann, in einer Beschichtungskammer 11 auf das zu beschichtende Substrat 15. Das Substrat 15 kann z. B. ein Stahlband sein, mit einer Dicke im Bereich von Mikrometern und einer Breite im Bereich von Millimetern. Das Substrat 15 kann aber auch andere Formen aufweisen, z. B. Drahtform mit rundem Querschnitt. Bei einem bandförmigen Substrat 15 mit rechteckigem Querschnitt, im Weiteren nur als bandförmiges Substrat 15 bezeichnet, weist der Ausgang der Düse 10 auf eine Oberfläche des Substratbandes 15, welche z. B. in der Breite über mehrere Millimeter ausgedehnt ist im Vergleich zu einer Seitenfläche des Substratbandes 15 mit einer Breite im Bereich von Mikrometern. Diese breite, flache Seite des Substrats 15 wird dann beim Auftreffen der Partikel des Aerosols mit dem Partikelmaterial beschichtet, z. B. mit MgB₂ Kristallit-Partikeln. Die Pulver-Partikel bleiben an dem Substrat 15 "kleben" oder haften und bilden so eine geschlossene supraleitende Schicht auf einer Seite des Substrats 15 aus.

Das bandförmige Substrat 15 wird kontinuierlich von einer Rolle 16, d.h. der Quell-Rolle abgewickelt, durch eine Eingangsschleuse 13 in die Beschichtungskammer 11 bewegt und an der Düse 10 vorbei über eine Ausgangsschleuse 14 aus der Beschichtungskammer 11 bewegt, um auf einer Rolle 17, d.h. der Zielrolle wieder aufgewickelt zu werden. Die beiden Rollen 16, 17 können gleich angetrieben sein und sich mit gleichem Drehsinn und gleicher Drehgeschwindigkeit bewegen. Alternativ kann auch nur eine Rolle, z. B. die Zielrolle 17 angetrieben sein, wobei das Substratband 15 durch Zugkraft von der Quellrolle 16 abgewickelt wird, oder bei angetriebener Quellrolle 16 kann durch Druckkraft das Substrat 15 auf der Zielrolle 17 aufgewickelt werden.

Um eine gleichmäßige supraleitende Schicht, d.h. mit gleichmäßiger Dicke über die gesamte eine Seite des Substrats 15 verteilt herzustellen, sollte die Vorschubgeschwindigkeit des Substrats 15, d.h. die Umfangsdrehgeschwindigkeit der Rollen 16, 17, konstant während des gesamten Beschichtungsprozesses sein. Die Düse 10 sollte das Aerosol mit gleichmäßiger Strömungsgeschwindigkeit abgeben, und die Partikelzahl und -Größe sollte im Aerosol nicht oder nicht stark schwanken. Vorteilhaft ist auch die Verwendung einer schlitzförmigen Düse 10, bei welcher die Längsichtung des Schlitzes parallel zur Breite und Oberfläche der zu beschichtenden Seite des Substratbandes 15 angeordnet ist. Die Ausbildung gleichmäßiger Schichten wird auch begünstigt, indem über die Schlitzlänge das Aerosol gleichmäßig abgegeben wird und es sich somit auf der dem Schlitz gegenüberliegend angeordneten Oberfläche des Substratbandes 15 gleichmäßig abscheiden kann.

Optional können, wie in Fig. 1 dargestellt, in der Beschichtungskammer 11 Evakuier-Anschlüsse 12 vorgesehen sein, über welche die Kammer 11 und/oder die Schleusen 13 und 14 evakuiert werden können. Alternativ kann über die Anschlüsse 12 auch ein Schutzgas, wie z. B. Stickstoff zugeführt werden. Dadurch kann in der Beschichtungskammer 11 entweder ein Unterdruck bis hin zu einem Vakuum erzeugt werden, oder eine Schutzgasatmosphäre. Verunreinigungen der supraleitenden Schicht durch Teilchen oder Bestandteile der Umgebungsluft können so ausgeschlossen werden. Es kann auch eine Oxidation von Bestandteilen der Partikel im Aerosol und somit der supraleitenden Schicht verhindert werden.

Es ist aber auch ein vereinfachter Aufbau der Anordnung ohne Evakuier-Anschlüsse 12 und/oder Schleusen 13, 14 möglich. Selbst eine Beschichtungskammer 11 ist unter Umständen nicht zwingend notwendig, wenn der Einfluss der Umgebungsluft bei der Abscheidung des Aerosols und der Ausbildung der supraleitenden Schicht nicht stört. Ein Vakuum kann zwar vorteilhaft sein, ein Hoch-Vakuum ist jedoch nicht notwendig. Das Verfahren ist selbst bei Atmosphären- bzw. Umgebungs-Druck anwendbar.

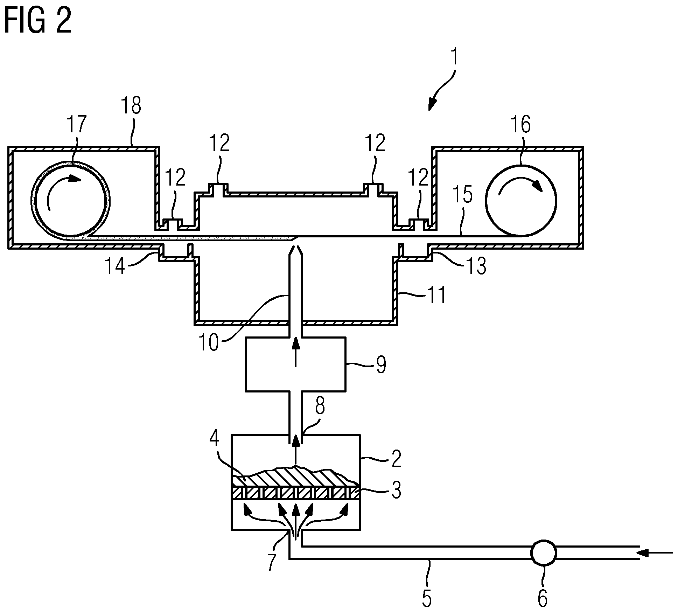

In Fig. 2 ist eine alternative Ausführungsform der erfindungsgemäßen Anordnung 1 dargestellt. Die Anordnung 1 ist analog der in Fig. 1 gezeigten Anordnung 1 ausgebildet, nur mit zusätzlich vollständig gekapselten Quell- und Zielrollen 16, 17. Somit ist der Innenraum der gesamten Anordnung Luftdicht abschließbar und z. B. über Evakuier-Anschlüsse 12, wie zuvor beschrieben evakuierbar oder mit Schutzgasatmosphäre befüllbar. Eine Oxidation oder Kontamination mit Staub und Schmutzpartikeln des mit einer supraleitenden Schicht beschichteten Substrats 15 kann so durch die Kapselung 18 ausgeschlossen werden, selbst beim Ab- und Aufwickeln. Nicht dargestellte Schleusen können vorgesehen sein, um eine vollständige Rolle 16, 17 der Anordnung zuzuführen oder zu entnehmen.

Zuvor beschriebene Ausführungsbeispiele können auch kombiniert werden. So kann z. B. nur eine Rolle 17 gekapselt sein, während das Substratband 15 von einer Rolle 16 der Beschichtungskammer 11 über eine Schleuse zugeführt wird. Bei einer vollständigen Kapselung 18 der Anordnung kann auf Schleusen 13 und 14 zum Zu- und Abführen des Substratbandes 15 zur Beschichtungskammer 11 auch verzichtet werden.

Das angegebene, erfindungsgemäße Verfahren und die Anordnung zur Ausführung des Verfahrens ermöglichen eine gleichmäßige Beschichtung von z. B. bandförmigen Substraten mit MgB₂ supraleitenden Schichten über große längen hinweg. So können die Substratbänder Längen im Bereich von Zentimetern bis hin zu einigen hundert Metern aufweisen. Die abgeschiedenen Schichten können mit gleichmäßigen Dicken, elektrisch gleichmäßigen Eigenschaften über die ganze Länge des Substratbandes hinweg bei Raumtemperatur hergestellt werden. Es werden so neue Aufbauten der Substratbänder mit supraleitenden Schichten möglich, welche z. B. aus Kupfer bestehen und keine Zwischenschichten zwischen dem Substrat und der supraleitenden Schichat als Diffusionsbarriere benötigen. Die geringe Abscheidetemperatur und die geringen Ansprüche an die Druckverhältnisse bei der Abscheidung (kein Hoch-Vakuum notwendig) führen zu einer Energieeinsparung gegenüber herkömmlichen Prozessen wie z. B. Sputtern. Es sind mit dem Verfahren dicke Schichten in hohem Durchsatz, d.h. kurzer Zeit herstellbar.

## Patentansprüche

1. Verfahren zur Herstellung von supraleitenden Schichten auf Substraten (15), wobei durch Aerosol-Deposition auf dem Substrat (15) eine supraleitende Schicht aus MgB₂ hergestellt wird, **dadurch gekennzeichnet, dass** das Verfahren als ein kontinuierlicher Durchlaufprozess durchgeführt wird, bei dem das Substrat kontinuierlich bereitgestellt wird.

2. Verfahren nach Anspruch 1, **dadurch gekennzeichnet, dass** das Substrat (15) von einer Rolle (16) kontinuierlich bereitgestellt wird.

3. Verfahren nach einem der vorhergehenden Ansprüche, **dadurch gekennzeichnet, dass** ein bandförmiges Substrat (15) verwendet wird.

4. Verfahren nach einem der vorhergehenden Ansprüche, **dadurch gekennzeichnet, dass** ein metallisches Substrat (15) verwendet wird, insbesondere ein Substrat (15) aus Kupfer oder Stahl.

5. Verfahren nach einem der vorhergehenden Ansprüche, **dadurch gekennzeichnet, dass** die supraleitende Schicht aus MgB₂ Pulver (4) hergestellt wird oder aus einem Pulvergemisch (4) von Mg und B, oder dass die supraleitende Schicht aus MgB₂ Pulver (4) und/oder Mg und B Pulver (4) gemischt mit Shunt-Material, insbesondere einer FeCr-Ni- oder Cu-Ni-Legierung, hergestellt wird.

6. Verfahren nach einem der vorhergehenden Ansprüche, **dadurch gekennzeichnet, dass** als Trägergas Helium, Stickstoff oder Luft verwendet wird.

7. Verfahren nach einem der vorhergehenden Ansprüche, **dadurch gekennzeichnet, dass** das Verfahren bei im wesentlichen Raumtemperatur, insbesondere 25°C durchgeführt wird.

8. Verfahren nach einem der vorhergehenden Ansprüche, **dadurch gekennzeichnet, dass** die supraleitende Schicht mit einer Schichtdicke von größer oder gleich 1µm erzeugt wird.

9. Verfahren nach einem der vorhergehenden Ansprüche, **dadurch gekennzeichnet, dass** das Verfahren in einer Beschichtungskammer (11) durchgeführt wird, welche wenigstens eine Schleuse (13, 14) aufweist, insbesondere eine Schleuse (13) zum Zuführen des Substrats (15) und eine Schleuse (14) zum Abführen des Substrats (15), für eine Trennung des Innenraums der Beschichtungskammer (11) von der Umgebungsatmosphäre der Beschichtungskammer (11).

10. Verfahren nach einem der Ansprüche 1 bis 8, **dadurch gekennzeichnet, dass** das Verfahren in einer Anordnung (1) durchgeführt wird, insbesondere einer Anordnung (1) mit einer Quellrolle (16) an Substrat (15) und/oder einer Zielrolle (17) für das beschichtete Substrat (15), und die Anordnung (1) vollständig gekapselt ist gegenüber der Umgebung zum luftdichten Abschluss des Verfahrens gegenüber der Umgebungsatmosphäre der Anordnung (1).

11. Verfahren nach einem der vorhergehenden Ansprüche, **dadurch gekennzeichnet, dass** auf die Aerosol-Deposition ein weiterer Beschichtungsprozess folgt, insbesondere eine Beschichtung zur Erzeugung einer Kupfer- und/oder Aluminium-Schicht.

12. Verfahren nach einem der Ansprüche 1 bis 10, **dadurch gekennzeichnet, dass** direkt folgend auf die Aerosol-Deposition ein Isolationsprozess durchgeführt wird.

13. Verfahren nach einem der vorhergehenden Ansprüche, **dadurch gekennzeichnet, dass** in einem ersten Schritt ein Trägergas in eine Aerosolkammer (2) über einen gasdurchlässigen Support (3) eintritt, wobei auf dem Support (3) Pulver (4) angeordnet wird, welches bei der Durchströmung des Supports (3) von dem Trägergas teilchenförmig aufgenommen wird, und in einem zweiten Schritt das Trägergas-Pulver-Gemisch über eine regel- oder steuerbare Düse (9), insbesondere einer Düse (9) in Schlitzform, in eine Beschichtungskammer (11) eingeleitet wird, wobei das Pulver (4) über einen Aerosol-Depositions-Prozess an einem kontinuierlich durch die Beschichtungskammer (11) bewegtem Substrat (15) abgeschieden wird.

14. Verfahren nach Anspruch 13, **dadurch gekennzeichnet, dass** zeitlich zwischen dem ersten und dem zweiten Schritt ein dritter Schritt erfolgt, bei welchem das Aerosol aus Pulver (4) und Trägergas durch einen Konditionierer (8) strömt, in welchem für die Deposition zu große Pulver-Teilchen (4) herausgefiltert werden und/oder eine Harmonisierung der kinetischen Energie der Pulver-Teilchen (4) erfolgt.

15. Anordnung (1) zur Herstellung von supraleitenden Schichten auf Substraten (15) nach einem Verfahren nach den Ansprüchen 2 und 3 und einem der Ansprüche 1 und 4 bis 14, umfassend eine Beschichtungskammer (11) mit wenigstens einem Eingang zur kontinuierlichen Zuführung eines auf einer Rolle (16) vorliegenden bandförmigen Substrates (15) und mit wenigstens einem Ausgang für das mit einer supraleitenden Schicht beschichtete bandförmige Substrat (15) und mit einer Vorrichtung zur Bereitstellung eines Aerosols zur Beschichtung des Substrats (15) mit MgB₂, die eine Aerosolkammer (2) mit einer Trägergaszuleitung (5) zur Herstellung eines Aerosols aus einem zugeführten Trägergas und einem in der Aerosolkammer enthaltenen Pulver aus MgB₂-Partikeln aufweist, wobei die Aerosolkammer (2) mit der Beschichtungskammer (11) zur Zufuhr des Aerosols in Verbindung steht.

## Claims

1. Method for producing superconducting layers on substrates (15), wherein a superconducting layer of MgB₂ is produced on the substrate (15) by aerosol deposition, **characterized in that** the method is carried out as a continuous-throughput process, in which the substrate is provided continuously.

2. Method according to Claim 1, **characterized in that** the substrate (15) is provided continuously from a roll (16).

3. Method according to one of the preceding claims, **characterized in that** a substrate (15) in web form is used.

4. Method according to one of the preceding claims, **characterized in that** a metal substrate (15) is used, in particular a substrate (15) consisting of copper or steel.

5. Method according to one of the preceding claims, **characterized in that** the superconducting layer is produced from MgB₂ powder (4) or from a powder mixture (4) of Mg and B, or **in that** the superconducting layer is produced from MgB₂ powder (4) and/or Mg and B powder (4) mixed with shunt material, in particular an FeCr-Ni or Cu-Ni alloy.

6. Method according to one of the preceding claims, **characterized in that** helium, nitrogen or air is used as a carrier gas.

7. Method according to one of the preceding claims, **characterized in that** the method is carried out essentially at room temperature, in particular 25°C.

8. Method according to one of the preceding claims, **characterized in that** the superconducting layer is produced with a layer thickness greater than or equal to 1 µm.

9. Method according to one of the preceding claims, **characterized in that** the method is carried out in a coating chamber (11) which has at least one air lock (13, 14), in particular an air lock (13) for supplying the substrate (15) and an air lock (14) for removing the substrate (15), for separation of the interior of the coating chamber (11) from the atmosphere surrounding the coating chamber (11).

10. Method according to one of Claims 1 to 8, **characterized in that** the method is carried out in an arrangement (1), in particular an arrangement (1) having a source roll (16) of substrate (15) and/or a target roll (17) for the coated substrate (15), and the arrangement (1) is fully encapsulated from the environment for airtight isolation of the method from the atmosphere surrounding the arrangement (1).

11. Method according to one of the preceding claims, **characterized in that** the aerosol deposition is followed by a further coating process, in particular coating to produce a copper and/or aluminum layer.

12. Method according to one of Claims 1 to 10, **characterized in that** an insulation process is carried out immediately after the aerosol deposition.

13. Method according to one of the preceding claims, **characterized in that** in a first step a carrier gas enters an aerosol chamber (2) through a gas-permeable support (3), powder (4) which is taken up in particle form by the carrier gas when it flows through the support (3) being arranged on the support (3), and in a second step the carrier gas/powder mixture is introduced into a coating chamber (11) through a regulable or controllable nozzle (9), particularly a nozzle (9) in slit form, the powder (4) being deposited by means of an aerosol deposition process on a substrate (15) moved continuously through the coating chamber (11).

14. Method according to Claim 13, **characterized in that** chronologically between the first and second steps, a third step is carried out in which the aerosol consisting of powder (4) and carrier gas flows through a conditioner (8), in which powder particles (4) which are too large for the deposition are filtered out and/or harmonization of the kinetic energy of the powder particles (4) takes place.

15. Arrangement (1) for producing superconducting layers on substrates (15) by a method according to Claims 2 and 3 and one of Claims 1 and 4 to 14, comprising a coating chamber (11) having at least one entry for continuous supply of a substrate (15) in web form which is present on a roll (16), and having at least one exit for the substrate (15) in web form coated with a superconducting layer, and having a device for providing an aerosol for coating the substrate (15) with MgB₂, which arrangement has an aerosol chamber (2) with a carrier gas supply line (5) for producing an aerosol from a supplied carrier gas and a powder, composed of MgB₂ particles, contained in the aerosol chamber, the aerosol chamber (2) being connected to the coating chamber (11) for the supply of the aerosol.

## Revendications

1. Procédé de production de couches supraconductrices sur des substrats (15), dans lequel on produit une couche supraconductrice en MgB₂ par dépôt d'aérosol sur le substrat (15), **caractérisé en ce que** l'on effectue le procédé sous la forme d'une opération de passage en continu dans laquelle on met le substrat à disposition en continu.

2. Procédé suivant la revendication 1, **caractérisé en ce que** l'on met le substrat (15) à disposition en continu par un rouleau (16).

3. Procédé suivant l'une des revendications précédentes, **caractérisé en ce que** l'on utilise un substrat (15) en forme de bande.

4. Procédé suivant l'une des revendications précédentes, **caractérisé en ce que** l'on utilise un substrat (15) métallique, notamment un substrat (15) en cuivre ou en acier.

5. Procédé suivant l'une des revendications précédentes, **caractérisé en ce que** l'on produit la couche supraconductrice en poudre (4) de MgB₂ ou en un mélange (4) de poudre de Mg et B ou **en ce que** l'on produit la couche supraconductrice en poudre (4) de MgB₂ et/ou en poudre (4) de Mg et B, mélangé à du matériau de shunt, notamment à un alliage en FeCr-Ni ou en Cu-Ni.

6. Procédé suivant l'une des revendications précédentes, **caractérisé en ce que** l'on utilise, comme gaz porteur, de l'hélium, de l'azote ou de l'air.

7. Procédé suivant l'une des revendications précédentes, **caractérisé en ce que** l'on effectue le procédé sensiblement à la température ambiante, notamment à 25°C.

8. Procédé suivant l'une des revendications précédentes, **caractérisé en ce que** l'on produit la couche supraconductrice en une épaisseur supérieure ou égale à 1µm.

9. Procédé suivant l'une des revendications précédentes, **caractérisé en ce que** l'on effectue le procédé dans une chambre (11) de revêtement, qui a au moins un sas (13, 14), notamment un sas (13) pour l'entrée du substrat (15) et un sas (14) pour la sortie du substrat (15), pour une séparation de l'intérieur de la chambre (11) de revêtement de l'atmosphère ambiante autour de la chambre (11) de revêtement.

10. Procédé suivant l'une des revendications 1 à 8, **caractérisé en ce que** l'on effectue le procédé dans un agencement (1), notamment dans un agencement (1) ayant un rouleau (16) source de substrat (15) et/ou un rouleau (17) cible pour le substrat (15) à revêtir et l'agencement (1) étant capsulé complètement par rapport à l'atmosphère ambiante pour fermer, d'une manière étanche à l'air, le procédé par rapport à l'atmosphère ambiante autour de l'agencement (1).

11. Procédé suivant l'une des revendications précédentes, **caractérisé en ce qu'**au dépôt de l'aérosol fait suite une autre opération de revêtement, notamment un revêtement de production d'une couche de cuivre et/ou d'aluminium.

12. Procédé suivant l'une des revendications 1 à 10, **caractérisé en ce que** l'on effectue une opération d'isolation directement à la suite du dépôt d'aérosol.

13. Procédé suivant l'une des revendications précédentes, **caractérisé en ce que**, dans un premier stade, un gaz porteur entre dans une chambre (2) d'aérosol par un support (3) perméable au gaz, dans lequel, sur le support (3), est disposée de la poudre (4) qui, à la traversée du support (3), est absorbée sous forme de particules par le gaz porteur et dans un deuxième stade, on envoie le mélange de gaz porteur et de poudre par une buse (9) pouvant être réglée ou commandée, notamment par une buse (9) sous la forme d'une fente, dans une chambre (11) de revêtement, la poudre (4) étant déposée par une opération de dépôt d'aérosol sur un substrat (15) déplacé en continu dans la chambre (11) de revêtement.

14. Procédé suivant la revendication 13, **caractérisé en ce qu'**il est effectué, dans le temps, entre le premier et le deuxième stade, un troisième stade, dans lequel l'aérosol, composé de poudre (4) et de gaz porteur, passe dans un conditionneur (8) dans lequel, pour le dépôt, des particules (4) de poudre trop grandes sont éliminées par filtration et/ou il se produit une harmonisation de l'énergie cinétique des particules (4) de poudre.

15. Agencement (1) de production de couches supraconductrices sur des substrats (15) suivant un procédé selon les revendications 2 et 3 et l'une des revendications 1 et 4 à 14, comprenant une chambre (11) de revêtement, ayant au moins une entrée pour l'entrée en continu d'un substrat (15) en forme de bande se présentant sur un rouleau (16) et comprenant au moins une sortie pour le substrat (15) en forme de bande revêtue d'une couche supraconductrice et comprenant un système de mise à disposition d'un aérosol pour revêtir le substrat (15) de MgB₂, qui a une chambre (2) d'aérosol, ayant une entrée (5) pour du gaz porteur, afin de produire un aérosol en un gaz porteur apporté et en une poudre en particules de MgB₂ contenue dans la chambre d'aérosol, la chambre (2) d'aérosol communiquant, pour l'apport de l'aérosol, avec la chambre (11) de revêtement.
